# EUROPÄISCHE PATENTSCHRIFT

(11) **EP 0 859 405 B1**
(45) Veröffentlichungstag und Bekanntmachung des Hinweises auf die Patenterteilung: **12.12.2007**
(21) Anmeldenummer: 98102023.3
(22) Anmeldetag: 05.02.1998
(51) Int. Cl.: H01L 21/02, H01L 21/8242

(54) **Herstellverfahren für eine erhabene Kondensatorelektrode**
Method of manufacturing a raised capacitor electrode
Méthode de fabrication d'une électrode saillante d'un condensateur

(30) Priorität: 12.02.1997 DE 19705352
(43) Veröffentlichungstag der Anmeldung: 19.08.1998
(73) Patentinhaber: Infineon Technologies AG, 81669 München (DE)
(72) Erfinder: Mazure-Espejo, Carlos, Dr., 85604 Zorneding (DE); Weinrich, Volker, Dr., 81549 München (DE)
(74) Vertreter: Müller - Hoffmann & Partner

(56) Entgegenhaltungen:
- US-A- 5 352 622
- PATENT ABSTRACTS OF JAPAN vol. 1999, no. 07, 31. März 1999 (1999-03-31) -& JP 08 330544 A (SAMSUNG ELECTRON CO LTD), 13. Dezember 1996 (1996-12-13) -& US 5 824 563 A

## Beschreibung

Die Erfindung betrifft ein Herstellverfahren für eine Kondensatorelektrode in einer integrierten Halbleiterschaltung mit den Merkmalen des Oberbegriffs des Patentanspruchs 1.

Integrierte Halbleiterschaltungen besitzen oft Kondensatoren, die während des Herstellprozesses erhaben sind, d.h. auf einer annähernd horizontalen Fläche hergestellt werden. Ein Beispiel dafür sind sogenannte "Stacked Capacitor"-Speicherzellen, insbesondere in DRAM-Bauelementen. Einen wesentlichen Einfluss auf den Platzbedarf eines solchen Kondensators hat die Wahl des Kondensatordielektrikums.

Konventionelle Kondensatoren benutzen als Speicherdielektrikum meist Siliziumoxid- bzw. -nitridschichten, die eine Dielektrizitätskonstante von maximal ca. 8 besitzen. Neue paraelektrische Materialien, wie beispielsweise BST (Barium-Strontium-Titanat, BaSrTiO3) und ähnliche besitzen eine Dielektrizifätskönstänte ε > 150 und ermöglichen somit einen kleineren Kondensator.

Derartige Speicherelemente mit einem paraelektrischen Material als Kondensatordielektrikum (DRAM) verlieren bei Ausfall der Versorgungsspannung ihre Ladung und somit ihre gespeicherte Information. Weiter müssen konventionelle Speicherelemente wegen des Rest-Leckstroms ständig neu beschrieben werden (Refresh-Time). Der Einsatz eines ferroelektrischen Materials als Speicherdielektrikum erlaubt aufgrund der unterschiedlichen Polarisationsrichtungen den Bau eines nichtflüchtigen Speichers, der seine Information bei Ausfall der Versorgungsspannung nicht verliert und nicht ständig neu beschrieben werden muss. Der Rest-Leckstrom der Zelle beeinflusst nicht das gespeicherte Signal. Ein Beispiel für ein derartiges ferroelektrisches Material ist PZT. (Blei-Zirkonium-Titanat, Pb(Zr,Ti)O₃).

Die Herstellung dieser neuen Ferro- und Paraelektrika erfolgt im allgemeinen bei hohen Temperaturen in einer oxidierenden Atmosphäre. Daher werden insbesondere für die erste Kondensatorelektrode Materialien benötigt, die mit diesen Bedingungen kompatibel sind. Ein geeignetes Material hierfür scheint eine Elektrode aus Platin zu sein. Die Strukturierung von Platin, insbesondere einer relativ dicken Platinschicht, ist aber ein bislang weitgehend ungelöstes Problem, da noch kein geeigneter Ätzprozess entwickelt wurde, und da keine flüchtigen Platin-Verbindungen für RIE-Prozesse geeignet zu sein erscheinen. Bisherige Ätzprozesse beruhen auf dem Aufbringen einer Lackmaske und Ätzen in Argon-, Sauerstoff- oder Chlorplasmen. Dabei kann wegen des physikalischen Anteils des Prozesses nur eine geringe Selektivität gegenüber Maskenmaterialien und Untergrund erzielt werden.

Im Einzelnen ist aus PATENT ABSTRACTS OF JAPAN Bd. 1999, Nr. 07, 31. März 1999 (1999-03-31) & JP 08 330544 A (SAMSUNG ELECTRON CO LTD), 13. Dezember 1996 (1996-12-13), ein Herstellverfahren für eine Kondensatorelektrode für eine Speicherzelle einer integrierten Halbleiterschaltung mit folgenden Schritten bekannt:
- Herstellen einer erhabenen Grundstruktur aus einem leitenden oder nichtleitenden Material auf einem Träger, die im Wesentlichen die geometrische Form der zu erzeugenden Kondensatorelektrode besitzt,
- Aufbringen eines leitenden Elektrodenmaterials in einem Sputterprozess, so dass die Schichtdicke an der Oberseite der Grundstruktur größer ist als an den Seitenwänden und auf der benachbarten Trägeroberfläche, und
- Durchführen eines anisotropen Ätzprozesses, so dass das Elektrodenmaterial auf der benachbarten Trägeroberfläche entfernt wird und auf der Oberseite und den Seitenwänden der Grundstruktur verbleibt.

Schließlich ist in EP-A-0 726 600 ein DRAM gezeigt, bei dem auf einem Siliziumsubstrat in einer Siliziumdioxidschicht ein aus Titansilizid/Polysilizium bestehender Pfropfen gelegen ist, der als Barrierenschicht zwischen dem Siliziumsubstrat und einer Titannitridschicht dient. Die Titannitridschicht ist von einer Platinschicht bedeckt, auf der eine BST-Schicht und eine obere Elektrode gelegen sind.

Aufgabe der vorliegenden Erfindung ist es, ein verbessertes Herstellverfahren für eine Kondensatorelektrode insbesondere aus Platin anzugeben; ferner soll das Herstellverfahren in den Herstellprozess einer DRAM-Zelle mit einem Hoch- ε-Paraelektrikum oder einem Ferroelektrikum als Speicherdielektrikum integrierbar sein.

Diese Aufgabe wird durch ein Herstellverfahren mit den Merkmalen des Patentanspruchs 1 gelöst.

Die Erfindung beruht darauf, zunächst die geometrische Form der zu bildenden Kondensatorelektrode aus einem leichter strukturierbaren Ersatzmaterial als sogenannte Grundstruktur zu bilden. Diese Grundstruktur ist erhaben auf einem Träger angeordnet und besitzt eine freiliegende Oberseite und freiliegende Seitenwände. Dann wird ein leitendes Elektrodenmaterial in einen Sputterprozess aufgebracht. Bei einem solchen Prozess ergibt sich auf der Oberseite der Grundstruktur eine grössere Schichtdicke als an den Seitenwänden und am Boden (d.h. auf der benachbarten freien Trägeroberfläche). Dann wird die Anordnung in einem anisotropen Ätzprozess rückgeätzt. Bei einer solchen Ätzung ist die Ätzrate auf horizontalen Oberflächen, also auf der Oberseite und am Boden (Träger) gleich schnell, an den Seitenwänden jedoch vernachlässigbar niedrig. Die Trägeroberfläche wird freigeätzt, d.h. das Elektrodenmaterial wird hier vollständig entfernt, an den Seitenwänden und an der Oberseite der Grundstruktur bleibt jedoch eine Schicht des Elektrodenmaterials stehen. Auf diese Weise erhält man eine isolierte Kondensatorelektrode, die beispielsweise von einer gleichzeitig gebildeten Kondensatorelektrode einer benachbarten Speicherzelle getrennt ist.

Bei der Erfindung braucht das Elektrodenmaterial, also beispielsweise Platin, nicht plasmachemisch strukturiert zu werden, stattdessen wird ein leichter zu ätzendes Ersatzmaterial zu einer Grundstruktur strukturiert. Die Ätzung des Elektrodenmaterials erfolgt ohne eine Lackmaske. Die zweite (obere) Elektrode kann bspw. durch einen Liftoff-Prozess strukturiert werden, so dass auch hier auf einen Plasmaätzprozess verzichtet werden kann.

Ein weiterer Vorteil ist es, dass zwischen der Abscheidung des Elektrodenmaterials und der Entfernung an Stellen ausserhalb der Elektrode kein Anlagenwechsel erforderlich ist.

Die Grundstruktur kann aus einem leitenden oder einem nicht leitenden Material gebildet werden. Bei der Integration in einen DRAM-Herstellprozess mit einem der genannten neuen Speicherdielektrika ist es vorteilhaft, die Grundstruktur aus einem Material zu bilden, das als SauerstoffDiffusionsbarriere bei dem späteren Hochtemperaturprozess wirkt und die Oxidation tieferliegender Strukturen verhindert. Die Kondensatorelektrode kann vorzugsweise über eine Anschlussstruktur mit einer Leitbahn oder einem leitfähigen Gebiet verbunden sein, und zwar mittels der Grundstruktur (falls diese leitend ist) oder mittels des Elektrodenmaterials.

Die Erfindung ist besonders vorteilhaft im Zellenfeld eines DRAM-Speichers einsetzbar, da durch die Vielzahl eng benachbarter Kondensatoren nur eine dünne Schicht des Elektrodenmaterials auf die Trägeroberfläche (relativ zur Oberseite der Grundstruktur) gesputtert wird, so dass im anisotropen Ätzprozess nur eine dünne Schicht entfernt werden muss.

Die Erfindung wird im folgenden anhand von Ausführungsbeispielen, die in den Zeichnungen dargestellt sind, näher erläutert. Es zeigen:

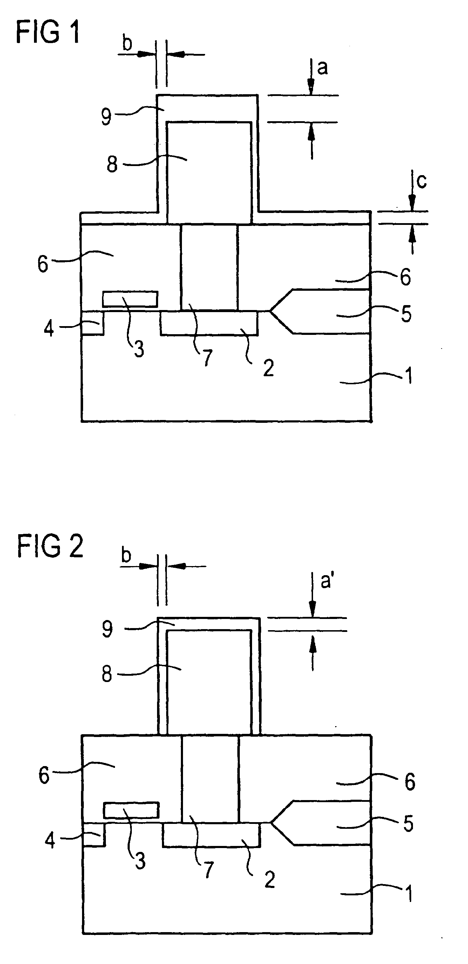

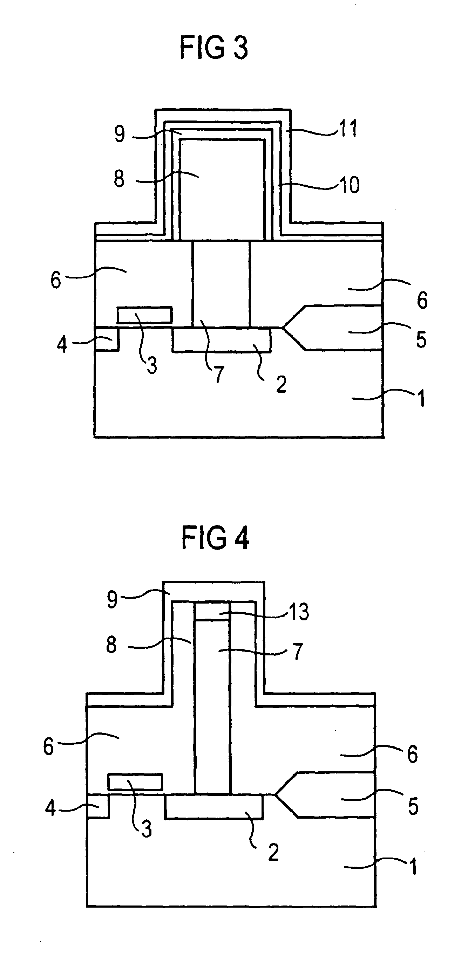

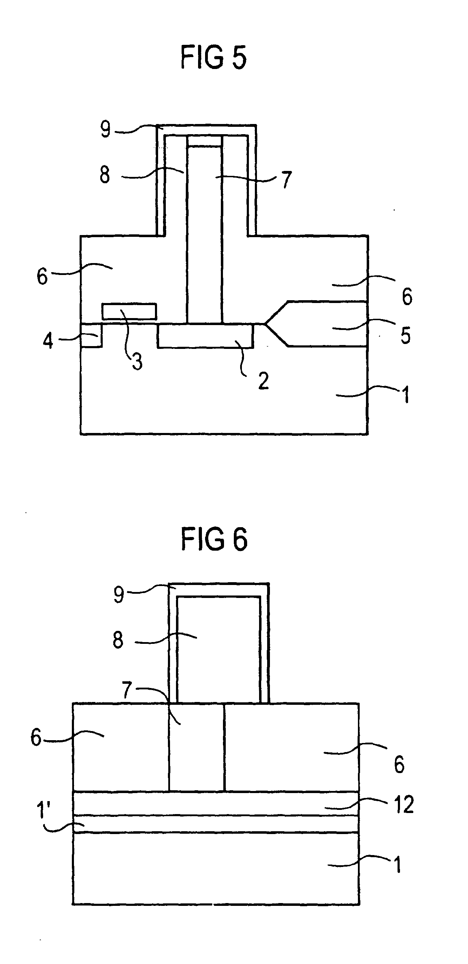

Figur 1 bis 3 einen Querschnitt durch eine Halbleiteranordnung, an der ein Ausführungsbeispiel des Verfahrens verdeutlicht wird, das für das Verständnis der Erfindung nützlich ist, Figuren 4 und 5 ein Ausführungsbeispiel der Erfindung, und Figur 6 ein weiteres Ausführungsbeispiel, das für das Verständnis der Erfindung nützlich ist. Die in Figur 1 bis 3 und Figur 6 gezeigten Ausführungsbeispiele sind nicht Teil der Erfindung.

### Figur 1:

Das Verfahren wird am Beispiel einer DRAM-Speicherzelle erläutert. In einem Silizium-Halbleitersubstrat 1 ist ein MOS-Transistor mit dotierten Gebieten 2, 4 und einem Gate 3 hergestellt, der durch ein Isolationsgebiet 5 von dem Transistor einer benachbarten Speicherzelle getrennt ist. Die Anordnung ist mit einer Isolationsschicht 6, aus zum Beispiel Siliziumoxid, abgedeckt und stellt so den Träger für den Kondensator dar. Über eine Anschlussstruktur 7 beispielsweise aus Wolfram oder Polysilizium, ist das dotierte Gebiet 2 durch die Isolationsschicht 6 hindurch anschliessbar. Auf dem Träger, der vorzugsweise eine planarisierte Oberfläche aufweist, wird als Ersatzmaterial zur Formung der Grundstruktur Titannitrid oder ein anderes leitfähiges Barrierenmaterial aufgebracht und mit Hilfe eines konventionellen Ätzprozesses strukturiert. Es wird so die Grundstruktur 8 gebildet, die die Anschlussstruktur 7 auf einer ausreichend grossen Fläche überlappt. Eine vollständige Bedeckung ist dabei nicht unbedingt notwendig. Die geometrischen Abmessungen der Grundstruktur 8 hängen vor allem von dem gewünschten Kapazitätswert ab. Ein typischer Wert für die Höhe (Schichtdicke) ist 500 nm. Auf die Anordnung wird nun Platin als Elektrodenmaterial 9 aufgesputtert. Die Sputterbedingungen werden geräteabhängig so gewählt, dass eine möglichst gute Kantenbedeckung und eine mikrokristalline Schicht erhalten werden. Aufgrund von Abschattungseffekten ist die Schichtdicke c auf der der Grundstruktur benachbarten Trägeroberfläche und an den Seitenwänden der Grundstruktur 8 (Dicke b) geringer als auf der Oberseite der Grundstruktur (Dicke a). In diesem Ausführungsbeispiel wird beim Abscheiden eines 100 nm dicken Platinfilms auf Titannitrid ein Schichtdickenverhältnis a:c:b für Oberseite, Trägeroberfläche und Seitenwand von etwa 3:1,5:1 erhalten. Die Schichtdicke auf der Oberseite entspricht der, die man unter denselben Bedingungen auf einem ebenen Substrat erhielte.

### Figur 2:

Diese Anordnung wird nun einer Sputterätzung unterworfen. Da Sputterätzungen gerichtet durch einen Ionenstrom erfolgen, ist die Ätzrate auf den horizontalen Flächen gleich schnell, an den annähernd vertikalen Seitenwänden jedoch vernachlässigbar. Die Ätzzeit wird so bemessen, dass die Platinschicht auf der der Grundstruktur benachbarten Trägeroberfläche entfernt wird, auf der Grundstruktur selbst aber nur gedünnt und nicht entfernt wird. Im Ausführungsbeispiel eines DRAM-Zellenfeldes bedeutet dies, dass die Kondensatorelektrode von einer benachbarten Elektrode getrennt ist. Zwischen Oberseite und Seitenwand besteht ein Schichtdickenverhältnis a':b des Elektrodenmaterials 9 von etwa 1,5:1. Die Kondensatorelektrode ist damit fertiggestellt.

### Figur 3:

Um den Speicherkondensator fertigzustellen, wird ein Kondensatordielektrikum 10, vorzugsweise ein Hoch- ε-Dielektrikum, ganzflächig aufgebracht. Im Fall eines FRAM wird stattdessen ein Ferroelektrikum abgeschieden. Geeignete Verfahren sind dem Fachmann geläufig (bspw. aus dem Artikel von C.Hwang, Appl.Phys.Lett.67,1995,S.2819f.). Da die Grundstruktur 8 aus einer Sauerstoffdiffusionsbarriere gebildet ist, wird dabei die Oberfläche der Anschlussstruktur 7 nicht oxidiert. (Andernfalls müsste zwischen Anschlussstruktur 7 und Dielektrikum 10 eine geeignete Barriere eingebaut werden.) Dann wird die obere Elektrode 11 beispielsweise ebenfalls aus Platin hergestellt.

### Figur 4, 5:

In diesem Ausführungsbeispiel der Erfindung wird die Grundstruktur 8 aus einem nichtleitenden Ersatzmaterial gebildet, beispielsweise aus Siliziumoxid oder Siliziumnitrid. Dieses Ersatzmaterial kann wie im ersten Beispiel auf dem vorzugsweise planarisierten Träger aufgebracht und zur Grundstruktur 8 strukturiert werden. Zur Vereinfachung des Prozesses kann die Grundstruktur 8 aus demselben Material wie die der Abdeckung der unterliegenden Strukturen bzw. der Planarisierung dienende Schicht 6 gebildet werden, d. h. die Schicht 6 wird in einer ausreichend grösseren Schichtdicke aufgebracht, um aus ihr sowohl den Träger als auch die Grundstruktur 8 zu bilden. Mit anderen Worten, die Grundstruktur wird aus einem Material des Trägers gebildet. Das Besputtern mit dem Elektrodenmaterial 9 (Fig.4) und die anisotrope Ätzung (Fig.5) erfolgen wie oben erläutert. Bei einem nichtleitenden Ersatzmaterial ist ein Anschluss des Elektrodenmaterials 9 erforderlich, hier also muss vom dotierten Gebiet 2 des Transistors ein leitfähiger Kontakt zum Elektrodenmaterial 9 hergestellt werden. Dies kann dadurch erfolgen, dass die Anschlussstruktur 7 bis zum Elektrodenmaterial 9 reicht und sich beispielsweise bis an die Oberseite der Grundstruktur 8 erstreckt. Sollte aufgrund späterer sauerstoffreicher Temperungen eine Barriere 13 zwischen dieser Anschlussstruktur 7 und dem Elektrodenmaterial nötig sein, so muss diese ebenfalls, bspw. wie dargestellt, eingebaut werden. Bei einer Anschlussstruktur aus W kann die Barriere 13 aus WN bestehen. Der Kondensator kann wie vorstehend erläutert fertiggestellt werden.

### Figur 6:

Bei einem nichtleitenden Ersatzmaterial für die Grundstruktur 8 kann der Anschluss des Elektrodenmaterials 9 auch durch eine versetzte Anordnung der Grundstruktur 8 erreicht werden. Die Anschlussstruktur 7 beispielsweise aus Wolfram oder Polysilizium hat dann Kontakt zum Elektrodenmaterial auf der Seitenwand der Grundstruktur. In diesem Ausführungsbeispiel ist ferner der Anschluss an eine tieferliegende Leitbahn 12 gezeigt, die auf einer isolierenden Schicht 1'aufliegt. Das übrige Verfahren kann wie beim Ausführungsbeispiel der Figuren 1 bis 3 durchgeführt werden.

## Patentansprüche

1. Herstellverfahren für eine Kondensatorelektrode in einer integrierten Halbleiterschaltung mit folgenden Schritten:
- Herstellen einer im wesentlichen die geometrische Form der zu erzeugenden Kondensatorelektrode besitzenden, erhabenen Grundstruktur (8) aus einem Ersatzmaterial auf einem Halbleitersubstrat (1),
- Aufbringen eines leitenden Elektrodenmaterial (9) in einem Sputterprozess, so dass die Schichtdicke an der Oberseite der Grundstruktur (8) größer ist als an den Seitenwänden der Grundstruktur (8) und auf dem Anteil der Halbleitersubstratoberfläche, der nicht von der Grundstruktur (8) bedeckt ist,
- Durchführen eines anisotropen Ätzprozesses, so dass das Elektrodenmaterial auf der Halbleitersubstratoberfläche entfernt wird und auf der Oberseite und den Seitenwänden der Grundstruktur (8) verbleibt,
**dadurch gekennzeichnet, dass**
- das Elektrodenmaterial (9) über eine leitende Anschlussstruktur (7) durch die Grundstruktur (8) hindurch mit einem leitenden Gebiet (2) im Halbleitersubstrat (1) verbunden wird,
- die Grundstruktur aus einem nichtleitenden Material gebildet wird, und
- zwischen der Anschlussstruktur (7) und dem Elektrodenmaterial (9) eine Sauerstoffdiffusionsbarriere (13) hergestellt wird.

2. Herstellverfahren nach Anspruch 1, bei dem als Elektrodenmaterial (9) Platin verwendet wird.

3. Herstellverfahren nach Anspruch 1 oder 2, bei dem als anisotroper Ätzprozess ein Sputter-Ätzprozess eingesetzt wird.

4. Herstellverfahren nach einem der Ansprüche 1 bis 3, bei dem ein Ferroelektrikum oder ein Paraelektrikum (10) auf der erzeugten Kondensatorelektrode und darauf eine zweite Kondensatorelektrode (11) aufgebracht werden.

5. Verwendung des Verfahrens nach einem der Ansprüche 1 bis 4 bei der Herstellung einer Speicherzelle.

## Claims

1. Manufacturing method for a capacitor electrode in an integrated semiconductor circuit, having the following steps:
- producing a raised basic structure (8) from a substitute material on a semiconductor substrate (1), which structure essentially has the geometrical shape of the capacitor electrode to be manufactured,
- applying a conducting electrode material (9) in a sputtering process so that the layer thickness on the topside of the basic structure (8) is greater than on the side walls of the basic structure (8) and on the fraction of the semiconductor substrate surface which is not covered by the basic structure (8),
- carrying out an anisotropic etching process so that the electrode material on the semiconductor substrate surface is removed and remains on the topside and the side walls of the basic structure (8),
**characterized in that**
- the electrode material (9) is connected through the basic structure (8) via a conducting connecting structure (7) to a conducting zone (2) in the semiconductor substrate (1),
- the basic structure is formed from a nonconducting material and
- an oxygen diffusion barrier (13) is produced between the connecting structure (7) and the electrode material (9).

2. Manufacturing method according to Claim 1, in which platinum is used as electrode material (9).

3. Manufacturing method according to Claim 1 or 2, in which a sputter-etching process is used as the anisotropic etching process.

4. Manufacturing method according to one of Claims 1 to 3, in which a ferroelectric material or a paraelectric material (10) is applied to the capacitor electrode produced, and a second capacitor electrode (11) is applied thereto.

5. Use of the method according to one of Claims 1 to 4 in manufacturing a memory cell.

## Revendications

1. Procédé de fabrication d'une électrode de condensateur dans un circuit intégré à semi-conducteur, comportant des étapes suivantes :
- fabrication d'une structure (8) de base en saillie en un matériau de remplacement sur un substrat (1) semi-conducteur, la structure (8) de base ayant sensiblement la forme géométrique de l'électrode de condensateur à fabriquer,
- dépôt d'un matériau (9) d'électrode conducteur par un processus de pulvérisation cathodique, de sorte que l'épaisseur de couche à la surface de la structure (8) de base est plus grande qu'au niveau des parois latérales de la structure (8) de base et à la partie de la surface du substrat semi-conducteur qui n'est pas recouverte de la structure (8) de base,
- mise en oeuvre d'un processus d'attaque anisotrope de sorte que le matériau d'électrode est éliminé de la surface du substrat à semi-conducteur et reste sur la surface supérieure et les parois latérales de la structure (8) de base, **caractérisé en ce que** le matériau (9) d'électrode est relié, par l'intermédiaire d'une structure (7) conductrice de connexion à travers la structure (8) de base, à une zone (2) conductrice dans le substrat (1) semi-conducteur,
- la structure de base est en un matériau qui n'est pas conducteur, et
- entre la structure (7) de connexion et le matériau (9) d'électrode il est produit une barrière (13) s'opposant à la diffusion de l'oxygène.

2. Procédé de fabrication suivant la revendication 1, dans lequel du platine est utilisé en tant que matériau (9) d'électrode.

3. Procédé de fabrication suivant la revendication 1 ou 2, dans lequel il est utilisé comme procédé d'attaque anisotrope un procédé d'attaque par pulvérisation cathodique.

4. Procédé de fabrication suivant l'une des revendications 1 à 3, dans lequel on dépose un ferroélectrique ou un para électrique (10) sur l'électrode de condensateur produite et au-dessus une deuxième électrode (11) de condensateur.

5. Utilisation du procédé suivant l'une des revendications 1 à 4, lors de la fabrication d'une cellule de mémoire.
